# EUROPÄISCHE PATENTANMELDUNG

(11) **EP 3 065 272 A1**
(43) Veröffentlichungstag der Anmeldung: **07.09.2016**
(21) Anmeldenummer: 15157992.7
(22) Anmeldetag: 06.03.2015
(51) Int. Cl.: H02K 11/00, G01R 31/34

(54) **Zustandsorientierte Wickelkopfüberwachung**

(71) Anmelder: Siemens Aktiengesellschaft, 80333 München (DE)
(72) Erfinder: Jungiewicz, Artur, 13086 Berlin (DE)

(57) **Zusammenfassung**

Die Erfindung betrifft ein Warnsystem (10) zur zustandsorientierten Überwachung eines Wickelkopfes (2) einer elektrischen rotierenden Maschine (1) mit mindestens einem Sensor (11,12). Um die Ausfallzeiten der elektrischen rotierenden Maschine durch eine präzise Zustandsaussage zu minimieren, wird vorgeschlagen, dass mindestens ein Sensor (11,12) als faseroptischer Sensor (11,12) ausgebildet ist und dafür vorgesehen ist, eine mechanische Beschädigung des Wickelkopfes (2) zu detektieren.

## Beschreibung

Die Erfindung betrifft ein Warnsystem zur zustandsorientierten Überwachung eines Wickelkopfes einer elektrischen rotierenden Maschine mit mindestens einem Sensor.

Weiterhin betrifft die Erfindung ein Verfahren zur Überwachung des Zustandes eines Wickelkopfes in einer elektrischen rotierenden Maschine mit mindestens einem derartigen Warnsystem.

Die Erfindung betrifft ferner eine elektrische rotierende Maschine mit mindestens einem oben beschriebenen Warnsystem

Ein derartiges Warnsystem kommt insbesondere bei sehr großen elektrischen rotierenden Maschinen, beispielweise Hochspannungsmotoren mit einer Leistung von mehr als 10kW, zum Einsatz.

Anlagenausfälle, beispielsweise in der Öl- und Gasindustrie, die durch Beschädigung der Wickelköpfe von derartigen Hochspannungsmotoren verursacht worden sind, haben dazu geführt, dass nach Mitteln gesucht wird, die es erlauben den Zustand eines Wickelkopfes verlässlich einzuschätzen. Eine derartige Vorrichtung zur Wickelkopfüberwachung soll eine präzise Zustandsaussage treffen und beim Auftreten von Beschädigungsindizien eine Einschätzung der verbleibenden Restlebensdauer der betroffenen Wickelköpfe ermöglichen. So werden die Ausfallzeiten der elektrischen rotierenden Maschine minimiert.

Aus WO 2013/010903 A2 ist ein Verfahren zur Überwachung von Wickelkopfschwingungen eines Generators bekannt, welches die folgenden Schritte umfasst: Erfassen von Schwingungen des Wickelkopfes während des Betriebs des Generators, transformieren von Signalen der Schwingungen in den Frequenzbereich, transformieren mehrerer Einzelschwingungen von Frequenzsignalen in den Modalbereich und bestimmen von Abweichungen der Modalformen und/oder Einzelstabschwingungen zu einem Referenzverhalten.

Aus EP 2 310 865 B1 ist ein Verfahren zum Überwachen des Betriebszustands einer elektrischen Maschine bekannt, bei dem durch einen über eine Luftstrecke auf zumindest einen Bestandteil der elektrischen Maschine ausgerichteten InfrarotSensor selektiv in einem Wellenlangenbereich einer Absorptionsbande eines bei Teilentladungen entstehenden Ionisationsproduktes, insbesondere von bei der Ionisation von Luft entstehenden Ozons, eine Strahlungsintensität gemessen wird und aus der gemessenen Strahlungsintensität zumindest eine Kenngroße für die Teilentladungsaktivität innerhalb der elektrischen Maschine als Maß für den Betriebszustand der elektrischen Maschine ermittelt wird.

Der Erfindung liegt die Aufgabe zugrunde, ein Warnsystem zur zustandsorientierten Überwachung eines Wickelkopfes einer elektrischen rotierenden Maschine anzugeben, welches die Ausfallzeiten der elektrischen rotierenden Maschine minimiert.

Diese Aufgabe wird erfindungsgemäß durch ein Warnsystem der eingangs genannten Art gelöst, wobei mindestens ein Sensor als faseroptischer Sensor ausgebildet ist und dafür vorgesehen ist, eine mechanische Beschädigung des Wickelkopfes zu detektieren.

Weiterhin wird die Aufgabe durch ein Verfahren zur Überwachung des Zustandes eines Wickelkopfes in einer elektrischen rotierenden Maschine mittels mindestens eines derartigen Warnsystems gelöst.

Die Aufgabe wird ferner durch eine elektrische rotierende Maschine mit mindestens einem derartigen Warnsystem gelöst.

Ein Warnsystem, welches einen Sensor aufweist, um eine mechanische Beschädigung eines Wickelkopfes zu detektieren ist besonders vorteilhaft, da durch eine Zustandsaussage über eine mechanische Beschädigung des Wickelkopfes eine Schätzung der Restlebensdauer durchgeführt und frühzeitig Ressourcen, insbesondere Personal und Ersatzteile, bereitgestellt werden können. Auf diese Weise werden lange Ausfallzeiten der elektrischen rotierenden Maschine vermieden. Weiterhin ist die Verwendung von faseroptischen Sensoren besonders vorteilhaft, weil diese in starken magnetischen Feldern, in schwer zugänglichen Bereichen und bei hohen Temperaturen einsetzbar sind. Durch diese Eigenschaften liefert ein faseroptischer Sensor, welcher in einer sehr großen elektrischen rotierenden Maschine, beispielweise Hochspannungsmotoren mit einer Leistung von mehr als einem Megawatt, verbaut ist, präzise und nahezu umgebungsunabhängige Aussagen über den Zustand des Wickelkopfes und benötigt nicht viel Bauraum. Weiterhin kann ein derartiger faseroptischer Sensor, welcher ausschließlich aus dielektrischen Materialien gefertigt ist, direkt am Wickelkopf eingesetzt werden und ist nicht störungsanfällig. Dies ermöglicht eine einfache kontinuierliche Überwachung des Zustands der Isolierung während des Betriebs.

In besonders vorteilhafter Weise weist das Warnsystem mindestens einen redundanten Sensor auf, der dafür vorgesehen ist, eine mechanische Beschädigung des Wickelkopfes zu detektieren. Durch die Verwendung von redundanter Sensorik erhöht sich die Präzision der Zustandsaussage, was die Fehlerwahrscheinlichkeit verringert.

Bei einer bevorzugten Ausführungsform ist ein erster Sensor als Staubsensor ausgebildet. Hierbei wird beispielsweise die Staubpartikelmenge in der Kühlluft der elektrischen Maschine am Wickelkopf ausgewertet, wobei es bei einer mechanischen Beschädigung des Wickelkopfes zu einer Erhöhung der Staubpartikelmenge in der Kühlluft kommt. Dies ist besonders vorteilhaft, da ein Staubsensor, beispielsweise ein faseroptischer Staubsensor, zuverlässig und kostengünstig eingesetzt werden kann. Weiterhin ist ein derartiger Staubsensor sehr klein und kann deshalb sehr nahe an der gewünschten Stelle eingesetzt werden.

Bei einer weiteren vorteilhaften Ausgestaltung ist ein zweiter Sensor als Schwingungsüberwachungssensor ausgebildet. Dies ist besonders vorteilhaft, da eine Änderung des Schwingungsverhaltens auf eine mechanische Beschädigung des Wickelkopfes hindeutet und das Schwingungsverhalten unkompliziert und schnell während des Betriebes gemessen und ausgewertet werden kann.

In vorteilhafter Weise sind mindestens zwei verschiedene redundante Sensoren, die dafür vorgesehen sind, eine mechanische Beschädigung des Wickelkopfes zu detektieren, als eine erste Warnstufe ausgebildet. So können frühzeitig Ressourcen, insbesondere Personal und Ersatzteile, bereitgestellt werden. Dies hat den Vorteil, dass lange Ausfallzeiten der elektrischen rotierenden Maschine vermieden werden. Dies führt zu einer erheblichen Einsparung an Betriebskosten.

Bei einer bevorzugten Ausführungsform weist die erste Warnstufe eine erste Signalquelle auf, welche dafür vorgesehen ist ein Signal zur Mobilisierung von Ressourcen auszugeben. Diese Signalquelle kann beispielsweise ein Lautsprecher sein, eine andere Möglichkeit kann beispielsweise ein am Computer angezeigter Alarm in einer Leitzentrale sein. Das Signal führt dazu, dass frühzeitig und effizient Ressourcen, insbesondere Personal und Ersatzteile, bereitgestellt werden.

In einer bevorzugten Ausführungsform ist mindestens ein weiterer Sensor dafür vorgesehen, eine Beschädigung einer Isolation des Wickelkopfes zu detektieren. Dies ist besonders vorteilhaft, da durch eine zuverlässige Aussage über den Zustand der Isolationen des Wickelkopfes ein Kurzschluss und damit ein längerer Ausfall und/oder eine weitere Beschädigung vermieden werden kann.

In einer weiteren vorteilhaften Ausgestaltung weist das Warnsystem mindestens einen redundanten weiteren Sensor auf, welcher dafür vorgesehen ist, eine Beschädigung einer Isolation des Wickelkopfes zu detektieren. Durch die Verwendung von redundanter Sensorik erhöht sich die Zuverlässigkeit der Aussage über den Zustand der Isolationen des Wickelkopfes, was die Fehlerwahrscheinlichkeit verringert.

In vorteilhafter Weise ist ein dritter Sensor als Teilentladungssensor ausgebildet und dafür vorgesehen, eine Beschädigung einer Isolierung des Wickelkopfes zu detektieren. Eine Teilentladung ist eine kurzzeitige, energiearme und lokal begrenzte Entladung in der Isolierung, die nicht sofort zu einem elektrischen Durchschlag führt, aber das Material der Isolierung irreversibel schädigt. Teilentladungen führen im Laufe der Zeit zu wachsenden sogenannten Teilentladungsbäumchen im Isoliermaterial, was schließlich zu einem Durchschlag führen kann. Eine Teilentladung, welche durch einen oben beschriebenen Sensor detektiert wird, führt also direkt zu einer Beschädigung der Isolierung.

Bei einer bevorzugten Ausführungsform ist ein vierter Sensor, welcher als Sensor zur Überwachung des magnetischen Flusses in einem Luftspalt ausgebildet ist, dafür vorgesehen, eine Beschädigung einer Isolierung des Wickelkopfes zu detektieren. Dies ist vorteilhaft, da die Änderung des magnetischen Flusses mit geringem Aufwand messbar ist und eine Änderung des magnetischen Flusses, insbesondere im Zusammenspiel mit der Detektion von Teilentladungen, auf eine Beschädigung einer Isolierung des Wickelkopfes zurückzuführen ist.

In einer weiteren vorteilhaften Ausgestaltung sind mindestens zwei verschiedene redundante Sensoren als eine zweite Warnstufe ausgebildet. Diese mindestens zwei verschiedenen redundanten Sensoren sind dafür vorgesehen, eine Beschädigung der Isolation des Wickelkopfes zu detektieren. Durch die Verwendung von redundanter Sensorik erhöht sich die Zuverlässigkeit der Aussage über eine unter Umständen vorliegende Beschädigung der Isolation des Wickelkopfes. Dies verringert die Fehlerwahrscheinlichkeit was zu einer Einsparung an Betriebskosten führt.

Bei einer weiteren vorteilhaften Ausführungsform weist die zweite Warnstufe eine zweite Signalquelle auf, welche dafür vorgesehen ist, ein Signal zum Stoppen der elektrischen rotierenden Maschine und zur Überprüfung der Isolierung eines Wickelkopfes auszugeben. Ein zweites Signal ist vorteilhaft, da die Maschine so rechtzeitig und vor Eintreten eines Kurzschlusses gestoppt und überprüft werden kann. Weitere Beschädigungen der Maschine und damit verbundene längere Ausfallzeiten werden so vermieden.

In einer weiteren vorteilhaften Ausgestaltung des erfindungsgemäßen Verfahrens überwacht in der ersten Warnstufe ein erster Sensor eine Änderung der Staubpartikelmenge und ein zweiter, zum ersten Sensor redundanter, Sensor überwacht eine Änderung der Schwingungen und/oder Schwingungsmuster. Die erste Warnstufe hat hierbei die Aufgabe eine mechanische Beschädigung des Wickelkopfes zu detektieren. Dies ist besonders vorteilhaft, da durch die Verwendung einer redundanten Sensorik die Zuverlässigkeit der Zustandsaussage erhöht wird.

Bei einer weiteren vorteilhaften Ausführungsform detektiert in der zweiten Warnstufe ein dritter Sensor Teilentladungen und ein vierter, zum dritten Sensor redundanter, Sensor überwacht einen magnetischen Fluss insbesondere im Luftspalt. Die zweite Warnstufe hat hierbei die Aufgabe eine Beschädigung der Isolierung eines Wickelkopfes zu detektieren. Dies ist vorteilhaft, da durch die Verwendung redundanten Sensorik die Zuverlässigkeit der Zustandsaussage erhöht wird.

In vorteilhafter Weise wird in der ersten Warnstufe, bei Überschreitung oder Unterschreitung eines Grenzwertes des ersten Sensors und/oder des zweiten Sensors, ein Signal zur Mobilisierung von Ressourcen ausgegeben. Dieser Grenzwert kann beispielsweise empirisch oder mathematisch ermittelt und in einer Auswerteeinheit hinterlegt sein. Dabei kann das Signal zur Mobilisierung von Ressourcen beispielsweise ein akustisches Signal und/oder eine Email sein. Durch die frühzeitige Mobilisierung der Ressourcen in der ersten Warnstufe kann in einem möglichen nächsten Schritt schnell und effizient reagiert werden.

In einer weiteren vorteilhaften Ausgestaltung wird in der zweiten Warnstufe, bei Überschreitung oder Unterschreitung eines Grenzwertes des dritten Sensors und/oder des vierten Sensors, ein Signal zum Stoppen der elektrischen rotierenden Maschine und zur Überprüfung der Isolierung eines Wickelkopfes ausgegeben. Hierbei kann das Signal zum Stoppen der elektrischen rotierenden Maschine und zur Überprüfung der Isolierung eines Wickelkopfes beispielsweise ein Steuersignal sein. Durch das frühzeitige Stoppen der Maschine werden ein möglicher Kurzschluss und damit verbundene weitere Beschädigungen der elektrischen rotierenden Maschine vermieden.

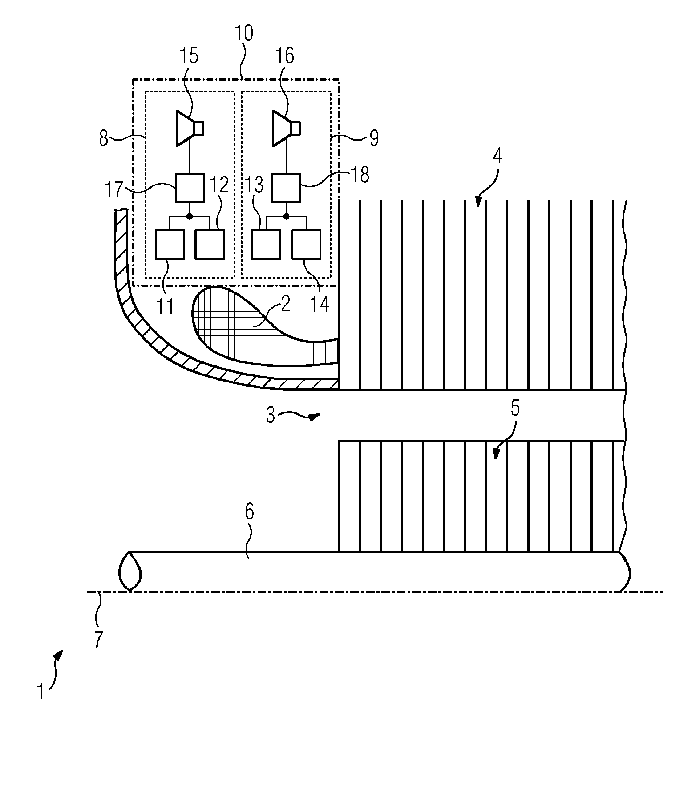

Im Folgenden wird die Erfindung anhand des in der Figur dargestellten Ausführungsbeispiels näher beschrieben und erläutert.

Die Figur zeigt einen schematischen Längsschnitt eines Teils einer elektrischen rotierenden Maschine 1 mit einer Ausführungsform eines Warnsystems 10 zur zustandsorientierten Überwachung eines Wickelkopfes 2. Die rotationssymmetrische Anordnung wird oberhalb einer Symmetrieachse 7 dargestellt. Im Ausschnitt der elektrischen rotierenden Maschine 1 sind Teile des Statorblechpakets 4 und des Rotorblechpakets 5, an dem sich die Antriebswelle 6 befindet, dargestellt, wobei sich ein Luftspalt 3 zwischen dem Statorblechpaket 4 und dem Rotorblechpaket 5 befindet. Aus dem Statorblechpaket 4 steht ein Wickelkopf 2 der in einem Stator eingezogenen Wicklungen hervor. Am Wickelkopf 2 befindet sich ein Warnsystem 10 zur zustandsorientierten Überwachung eines Wickelkopfes 2. Der Rotor der elektrischen rotierenden Maschine 1 kann ebenfalls einen Wickelkopf 2 und somit auch mindestens ein derartiges Warnsystem 10 aufweisen. Ein solches Warnsystem 10 soll beim Auftreten von ersten Indizien, die auf eine Beschädigung eines Wickelkopfes 2 hindeuten, eine Einschätzung der verbleibenden Lebensdauer ermöglichen, um die Auswirkung der detektierten Beschädigung auf die Ausfallzeiten der elektrischen rotierenden Maschine 1 zu begrenzen.

Bei der vorliegenden Ausführungsform des beschriebenen Warnsystems 10 handelt es sich um ein zweistufiges Warnsystem 10, welches eine erste Warnstufe 8 und eine zweite Warnstufe 9 aufweist. In jeder Warnstufe 8, 9 befinden sich mindestens zwei verschiedene redundante Sensoren 11, 12; 13, 14. Die Sensoren 11, 12 der ersten Warnstufe 8 sind mit einer ersten Auswerteeinheit 17 verbunden, an welche eine zweite Signalquelle 16 angeschlossen ist. Die Sensoren 13, 14 der zweiten Warnstufe 9 sind unabhängig von der ersten Warnstufe 8 mit einer zweiten Auswerteeinheit 18 verbunden, an welche eine zweite Signalquelle 16 angeschlossen ist. Jeder Sensor 11, 12, 13, 14 kann auch mehrfach in der rotationssymmetrischen Anordnung vorliegen und/oder mehrere Sensorelemente aufweisen, um möglichst exakte Sensordaten liefern zu können.

Durch die Verwendung von redundanter Sensorik mit mindestens zwei verschiedenen redundanten Sensoren 11, 12; 13, 14 erhöht sich die Präzision der Aussage zum Zustand der Wickelköpfe, was die Fehlerwahrscheinlichkeit des Warnsystems 10 verringert. Der Einsatz des zweistufigen Warnsystems 10 ermöglicht eine präzise Planung von Maßnahmen zur Abhilfe im Fall einer Beschädigung.

Das wird insbesondere durch eine empirische Ermittlung der Zeiträume ermöglicht, die zwischen einer mechanischen Beschädigung des Wicklungssystems, einer Beschädigung der Isolationen der Leiter der Wickelköpfe 2, und einem auftretenden Kurzschluss, welcher zum Ausfall der elektrischen rotierenden Maschine 1 führt, vergehen. Die mechanische Beschädigung des Wicklungssystems wird mit Hilfe der Sensoren 11, 12 der ersten Warnstufe 8 ermittelt. Diese Sensoren 11, 12 können beispielsweise ein Staubsensor und ein Schwingungsüberwachungssensor sein. Die Beschädigung der Isolationen der Leiter der Wickelköpfe 2 wird mit Hilfe der Sensoren 13, 14 der zweiten Warnstufe 9 bestimmt. Diese Sensoren 13, 14 können beispielsweise ein Teilentladungssensor und ein Sensor zur Überwachung des magnetischen Flusses sein. Das Warnsignal der ersten Signalquelle 15 der ersten Warnstufe 8 ist ein Signal zur Mobilisierung von Ressourcen, insbesondere von Personal und Ersatzteilen. Diese Signalquelle 15 kann ein akustisches Signal ausgeben oder auch eine SMS, ein Fax, eine E-Mail oder Ähnliches an die für die elektrische rotierende Maschine 1 verantwortliche Person schicken. Eine andere Möglichkeit der Signalausgabe ist beispielsweise ein am Computer angezeigter Alarm in einer Leitzentrale. Währenddessen kann die elektrische rotierende Maschine 1 weiter betrieben werden. Beim Auftreten des Warnsignals der zweiten Signalquelle 16 der zweiten Warnstufe 9 sind die elektrische rotierende Maschine 1 zu stoppen und der Zustand der Isolierung zu überprüfen bevor die elektrische rotierende Maschine 1 weiter betrieben werden kann. Die elektrische rotierende Maschine 1 kann, beispielsweise mit Hilfe einer Steuerung, automatisiert zur Überprüfung des Zustands der Isolierung gestoppt werden. Mit Hilfe der in der Zwischenzeit mobilisierten Ressourcen werden die elektrische rotierende Maschine 1 oder kritische Komponenten der elektrischen rotierenden Maschine 1 repariert und/oder ausgetauscht.

Die Verwendung von beispielsweise faseroptischen Sensoren 11, 12, 13, 14 ist vorteilhaft, weil diese in starken magnetischen Feldern, in schwer zugänglichen Bereichen und bei hohen Temperaturen einsetzbar sind. Durch diese Eigenschaften liefert ein faseroptischer Sensor, welcher in einer sehr großen elektrischen rotierenden Maschine, beispielweise Hochspannungsmotoren mit einer Leistung von mehr als einem Megawatt, verbaut ist, präzise und von der Umgebung nahezu unabhängige Aussagen über den Zustand des Wickelkopfes und benötigt nicht viel Bauraum. Die oben beschriebene Kombination der Sensoren 11, 12, 13, 14 erlaubt eine eindeutige Identifikation einer mechanischen Beschädigung des Wicklungssystems. Dabei wird in der ersten Warnstufe 8 gleichzeitig auf Änderungen der Schwingungsmuster der Wickelköpfe 2 und auf eine Zunahme der Staubpartikelmenge in der Kühlluft an den Wickelköpfen 2 der elektrischen rotierenden Maschine 1 geachtet. In der zweiten Warnstufe 9, welche Informationen bezüglich der direkten Beschädigung der Wicklungsisolation der Wickelköpfe 2 liefert, kommt ein Teilentladungsmesssystem und ein System zur Überwachung des magnetischen Flusses im Luftspalt der elektrischen rotierenden Maschine 1 zum Einsatz. Die Teilentladungen, abgekürzt TE, können mit einer konventionellen TE-Auskopplung am Kabelende über einen Koppelkondensator und eine Messimpedanz gemessen werden. Um eine höhere Messempfindlichkeit zu erreichen werden bevorzugt Feldsensoren, beispielsweise kapazitive Sensoren, Richtkoppelsensoren und/oder induktive Sensoren, zur TE-Detektion mittels Feldkopplung eingesetzt, die von TE-Impulsen erzeugte elektrische und magnetische Feldkomponenten erfassen und in messbare Spannungssignale umwandeln. Ein faseroptischer Sensor zur Überwachung des magnetischen Flusses im Luftspalt der elektrischen rotierenden Maschine 1, welcher beispielsweise den Faraday-Effekt nutzt, arbeitet ganz ohne magnetische Beeinflussung des Leiters und bietet überdies eine Potentialtrennung auch bei sehr hohen elektrischen Spannungen.

In der ersten Warnstufe 8 überwacht ein erster Sensor 11 die Staubpartikelmenge und/oder Änderungen der Staubpartikelmenge und ein zweiter, zum ersten Sensor 11 redundanter, Sensor 12 überwacht Schwingungen und/oder Schwingungsmuster und/oder deren Änderung. Die erste Warnstufe 8 hat hierbei die Aufgabe eine mechanische Beschädigung des Wickelkopfes 2 zu detektieren. Die Sensordaten werden von einer ersten Auswerteeinheit 17 ausgewertet. In der ersten Auswerteeinheit 17 sind Grenzwerte, Messwerte und/oder Algorithmen hinterlegt, welche als Referenz dienen. Überschreiten beispielsweise die erfassten Daten beider Sensoren 11, 12 einen absoluten oder relativen Grenzwert, aktiviert die erste Auswerteeinheit 17 die erste Signalquelle 15, welche ein Signal zur Mobilisierung von Ressourcen ausgibt. Dabei kann das Signal zur Mobilisierung von Ressourcen beispielsweise ein akustisches Signal und/oder eine Email sein. Durch die frühzeitige Mobilisierung der Ressourcen in der ersten Warnstufe 8 kann in einem möglichen nächsten Schritt schnell und effizient reagiert werden.

In der zweiten Warnstufe 10 detektiert ein dritter Sensor 13 Teilentladungen und ein vierter, zum dritten Sensor 13 redundanter, Sensor 14 überwacht einen magnetischen Fluss insbesondere im Luftspalt 3. Die zweite Warnstufe 9 hat hierbei die Aufgabe eine Beschädigung der Isolierung eines Wickelkopfes 2 zu detektieren. Die Sensordaten werden von einer zweiten Auswerteeinheit 18 ausgewertet. Auch in der zweiten Auswerteeinheit 18 sind Grenzwerte, Messwerte und/oder Algorithmen hinterlegt, welche als Referenz dienen. Überschreiten beispielsweise die erfassten Daten beider Sensoren 13, 14 einen absoluten oder relativen Grenzwert, aktiviert die zweite Auswerteeinheit 18 die zweite Signalquelle 16, welche ein Signal zum Stoppen der elektrischen rotierenden Maschine 1 und zur Überprüfung der Isolierung eines Wickelkopfes 2 ausgibt. Hierbei kann das Signal zum Stoppen der elektrischen rotierenden Maschine 1 und zur Überprüfung der Isolierung eines Wickelkopfes 2 beispielsweise ein Steuersignal sein. Durch das frühzeitige Stoppen der elektrischen rotierenden Maschine 1 werden ein möglicher Kurzschluss und damit verbundene weitere Beschädigungen vermieden.

Zusammenfassend betrifft die Erfindung ein Warnsystem 10 zur zustandsorientierten Überwachung eines Wickelkopfes 2 einer elektrischen rotierenden Maschine 1 mit mindestens einem Sensor 11, 12. Um die Ausfallzeiten der elektrischen rotierenden Maschine durch eine präzise Zustandsaussage zu minimieren, wird vorgeschlagen, dass mindestens eine Sensor 11, 12 als faseroptischer Sensor ausgebildet ist und dafür vorgesehen ist, eine mechanische Beschädigung des Wickelkopfes 2 zu detektieren.

## Patentansprüche

1. Warnsystem (10) zur zustandsorientierten Überwachung eines Wickelkopfes (2) einer elektrischen rotierenden Maschine (1), aufweisend mindestens einen Sensor (11,12), **dadurch gekennzeichnet, dass** mindestens ein Sensor (11,12) als faseroptischer Sensor ausgebildet ist und dafür vorgesehen ist, eine mechanische Beschädigung des Wickelkopfes (2) zu detektieren.

2. Warnsystem (10) nach Anspruch 1, **dadurch gekennzeichnet, dass** das Warnsystem (10) mindestens einen redundanten Sensor (11,12) aufweist, der dafür vorgesehen ist, eine mechanische Beschädigung des Wickelkopfes (2) zu detektieren.

3. Warnsystem (10) nach einem der Ansprüche 1 oder 2, **dadurch gekennzeichnet, dass** ein erster Sensor (11) als Staubsensor ausgebildet ist.

4. Warnsystem (10) nach einem der Ansprüche 1 bis 3, **dadurch gekennzeichnet , dass** ein zweiter Sensor (12) als faseroptischer Schwingungsüberwachungssensor ausgebildet ist.

5. Warnsystem (10) nach einem der Ansprüche 2 bis 4, **dadurch gekennzeichnet, dass** mindestens zwei verschiedene redundante Sensoren (11,12), die dafür vorgesehen sind, eine mechanische Beschädigung des Wickelkopfes zu detektieren, als eine erste Warnstufe (15) ausgebildet sind.

6. Warnsystem (10) nach Anspruch 5, **dadurch ge- kennzeichnet**, dass die erste Warnstufe (15) eine erste Signalquelle (19) aufweist, welche dafür vorgesehen ist ein Signal zur Mobilisierung von Ressourcen auszugeben.

7. Warnsystem (10) nach einem der vorherigen Ansprüche, **dadurch gekennzeichnet , dass** mindestens ein weiterer Sensor (13,14) dafür vorgesehen ist, eine Beschädigung einer Isolation des Wickelkopfes (2) zu detektieren.

8. Warnsystem (10) nach Anspruch 7, **dadurch gekennzeichnet, dass** das Warnsystem (10) mindestens einen redundanten Sensor (13,14) aufweist, welcher dafür vorgesehen ist, eine Beschädigung einer Isolation des Wickelkopfes (2) zu detektieren.

9. Warnsystem (10) nach einem der Ansprüche 7 oder 8, **dadurch gekennzeichnet, dass** ein dritter Sensor (13) als Teilentladungssensor ausgebildet ist und dafür vorgesehen ist, eine Beschädigung einer Isolierung des Wickelkopfes (2) zu detektieren.

10. Warnsystem (10) nach einem der Ansprüche 7 bis 9, **dadurch gekennzeichnet, dass** ein vierter Sensor (14), welcher als Sensor zur Überwachung des magnetischen Flusses in einem Luftspalt (3) ausgebildet ist, dafür vorgesehen ist, eine Beschädigung einer Isolierung des Wickelkopfes (2) zu detektieren.

11. Warnsystem (10) nach einem der Ansprüche 8 bis 10, **dadurch gekennzeichnet, dass** mindestens zwei verschiedene weitere redundante Sensoren (13,14) als eine zweite Warnstufe (16) ausgebildet sind.

12. Warnsystem (10) nach Anspruch 10, **dadurch ge-kennzeichnet,** dass die zweite Warnstufe (16) eine zweite Signalquelle (20) aufweist, welche dafür vorgesehen ist, ein Signal zum Stoppen der elektrischen rotierenden Maschine (1) und zur Überprüfung der Isolierung eines Wickelkopfes (2) auszugeben.

13. Verfahren zur Überwachung des Zustandes eines Wickelkopfes (2) in einer elektrischen rotierenden Maschine (1) mittels mindestens eines Warnsystems (10) nach einem der Ansprüche 1 bis 12.

14. Verfahren nach Anspruch 13, wobei in der ersten Warnstufe (8) ein erster Sensor (11) eine Änderung der Staubpartikelmenge überwacht und ein zweiter, zum ersten Sensor (11) redundanter, Sensor (12) eine Änderung der Schwingungen und/oder Schwingungsmuster überwacht.

15. Verfahren nach Anspruch 14, wobei in der zweiten Warnstufe (9) ein dritter Sensor (13) Teilentladungen detektiert und ein vierter, zum dritten Sensor (13) redundanter, Sensor (14) einen magnetischen Fluss insbesondere im Luftspalt überwacht.

16. Verfahren nach einem der Ansprüche 14 oder 15, wobei in der ersten Warnstufe (8), bei Überschreitung oder Unterschreitung eines Grenzwertes des ersten Sensors (11) und/oder des zweiten Sensors (12), ein Signal zur Mobilisierung von Ressourcen ausgegeben wird.

17. Verfahren nach einem der Ansprüche 14 bis 16, wobei in der zweiten Warnstufe (9), bei Überschreitung oder Unterschreitung eines Grenzwertes des dritten Sensors (13) und/ oder des vierten Sensors (14), ein Signal zum Stoppen der elektrischen rotierenden Maschine (1) und zur Überprüfung der Isolierung eines Wickelkopfes (2) ausgegeben wird.

18. Elektrische rotierende Maschine (1) mit mindestens einem Warnsystem (10) nach einem der Ansprüche 1 bis 12.
